Europäisches Patentamt

European Patent Office

Office européen des brevets

(11) Veröffentlichungsnummer: **0 364 949**

**A2**

# (12) EUROPÄISCHE PATENTANMELDUNG

(21) Anmeldenummer: **89119254.4**

(22) Anmeldetag: **17.10.89**

(51) Int. Cl.5: **G03F 7/022**

(30) Priorität: **20.10.88 DE 3835737**

(43) Veröffentlichungstag der Anmeldung:
**25.04.90 Patentblatt 90/17**

(84) Benannte Vertragsstaaten:
**AT CH DE FR GB IT LI NL SE**

(71) Anmelder: **CIBA-GEIGY AG**
**Klybeckstrasse 141**
**CH-4002 Basel(CH)**

(72) Erfinder: **Bartmann, Ekkehard, Dr.**
**Dieburger Weg 12a**
**D-6106 Erzhausen(DE)**
Erfinder: **Schulz, Reinhard, Dr.**
**Im Trappengrund 44**
**D-6107 Reinheim(DE)**
Erfinder: **Münzel, Horst, Dr.**
**Gruobachstrasse 60**
**D-7410 Reutlingen 2(DE)**

(74) Vertreter: **Zumstein, Fritz, Dr. et al**
**Bräuhausstrasse 4**
**D-8000 München 2(DE)**

(54) **Positiv-Fotoresists mit erhöhter thermischer Stabilität.**

(57) Die Erfindung betrifft Positiv-Fotoresists auf Basis von alkalilöslichem Phenolharz und fotoempfindlichen Chinondiazidverbindungen, bei denen durch bestimmte Additive damit hergestellten Reliefstrukturen eine erhöhte Stabilität gegenüber Veränderungen durch thermische Einwirkungen aufweisen.

EP 0 364 949 A2

## Positiv-Fotoresists mit erhöhter thermischer Stabilität

Die Erfindung betrifft Positiv-Fotoresists, bei denen damit hergestellte Reliefstrukturen eine erhöhte Stabilität gegenüber Veränderungen durch thermische Einwirkungen aufweisen.

Als Fotoresists werden üblicherweise fotostrukturierbare organische Polymermaterialien bezeichnet, die in photolithographischen Prozessen und verwandten Techniken eingesetzt werden, beispielsweise bei der Herstellung von Druckplatten, von gedruckten elektrischen Schaltungen und Leiterplatten oder insbesondere in der Mikroelektronik bei der Herstellung von integrierten Halbleiterbauelementen.

Zur Erzeugung der Schaltungsstrukturen bei der Herstellung von integrierten mikroelektronischen Halbleiterbauelementen wird das Halbleitersubstratmaterial mit dem Fotoresist beschichtet; durch bildmässiges Belichten der Fotoresistschicht und anschliessendes Entwickeln werden dann positive oder negative Fotoresistreliefstrukturen erhalten. Diese dienen als Maske für die eigentlichen Strukturierungsprozesse am Halbleitersubstrat wie Aetzen, Dotieren, Beschichten mit Metallen, anderen Halbleiter- oder auch Isolatormaterialien. Danach werden die Fotoresistmasken in der Regel wieder entfernt. Durch eine Vielzahl derartiger Prozesszyklen entstehen auf dem Substrat die Schaltungsstrukturen der Mikrochips.

Positiv-Fotoresists üblicher Art enthalten in einem organischen Lösungsmittel im wesentlichen mindestens je ein in wässrigen Alkalien lösliches Harz und eine fotoempfindliche Chinondiazidverbindung, die die Alkalilöslichkeit des Harzes reduziert, sowie üblicherweise noch weitere modifizierende Zusätze. Durch Strahlungseinwirkung auf mit derartigen Zusammensetzungen erzeugte Fotoresistschichten wird die Alkalilöslichkeit in den belichteten Bereichen durch fotoinduzierte strukturelle Umwandlung der Chinondiazidverbindung in ein Carbonsäurederivat erhöht, so dass nach Entwicklung in wässrig-alkalischen Entwicklungsbädern positive Fotoresist-Reliefstrukturen erhalten werden.

Die ständig fortschreitende Miniaturisierung in der Halbleitertechnologie und Mikroelektronik stellt an die Fotoresist-Materialien und die damit darzustellenden Reliefstrukturen höchste Anforderungen.

Neben Empfindlichkeit, Auflösung und Kontrast des Fotoresist, Haftfestigkeit sowie mechanische und chemische Stabilität des Fotoresist-Materials bzw. der erzeugten Reliefstrukturen während der weiteren Brozessschritte, wie insbesondere Entwickeln und Plasmaätzen, kommt der Dimensionstreue und Beständigkeit der Fotoresist-Reliefstrukturen bei Einwirkung erhöhter Temperaturen besondere Bedeutung zu. Ueblicherweise werden die nach Belichtung und Entwicklung erhaltenen Fotoresist-Reliefstrukturen einem Erhitzungsschritt (post bake) unterzogen, bei dem Temperaturen deutlich über 100 °C, meist zwischen 120° und 180 °C, einwirken. Dieser Schritt dient der Ausheizung von noch enthaltenen flüchtigen Bestandteilen, wodurch eine bessere Substrathaftung und Härtung der Resiststrukturen und eine Verringerung der Erosion bei anschliessenden Plasmaätzschritten bewirkt werden soll. Auch während des Plasmaätzens treten Temperaturen dieses Bereiches auf.

Positiv-Fotoresists auf Basis von alkalilöslichem Harz und Chinondiazidverbindungen haben aber häufig eine nicht ausreichende thermische Stabilität. Dies zeigt sich darin, dass sich bei Temperatureinwirkung von mehr als 120 °C die Resiststrukturen durch Fliessvorgänge zu verformen beginnen, wodurch Kantenschärfe und Kantensteilheit, aber auch die Geometrie der Strukturen leiden. Die Masshaltigkeit der Strukturübertragung auf das Substrat wird dadurch beeinträchtigt.

Es ist möglich, die thermische Stabilität von Positiv-Fotoresist-Reliefstrukturen durch Nachbehandlungsmassnahmen, wie etwa Bestrahlung mit mittlerem oder tiefem UV, oder durch chemische Nachbehandlung, wie z.B. mit Formaldehyd, zu verbessern. Derartige Nachbehandlungsmassnahmen haben zum Ziel, eine Vernetzung innerhalb der entwickelten Fotoresist-Reliefstrukturen zu bewirken, um die Erweichungs- bzw. Fliesstemperatur des Materials zu erhöhen. Bei zusätzlicher UV-Bestrahlung besteht die Gefahr, dass Blasen oder Abplatzungen in den Resiststrukturen entstehen, die die Ausbeute reduzieren. Alle derartigen Massnahmen bringen zusätzlichen Aufwand und sind zeitintensiv; die chemische Nachbehandlung bringt weitere Probleme, wie Kompatibilität sowie mögliche Toxizität und Fragen der Handhabung und Entsorgung der eingesetzten Chemikalien, mit sich.

Zur Verbesserung der thermischen Stabilität von Fotoresists sind auch bereits Zusätze verschiedenster Art zu den Resistformulierungen selbst vorgeschlagen worden, beispielsweise Hexamethylentetramin in Research Disclosure, June 1984, No. 24205, Peroxide in W.M. Moreau, Microcircuit Engineering 1983, Seite 321 ff, Azide in EP-A-0 140 376 und Dialkylbenzylaminderivate in JP-Kokai 61-36742. Derartige Zusätze haben ebenfalls die Vernetzung des Fotoresistmaterials zum Ziel.

Azide und Peroxide sind jedoch gegenüber UV-Strahlung, wie sie in der Fotoresisttechnik angewendet wird, empfindlich und bewirken durch fotoinduzierte Radikalbildung eine Vernetzung in den belichteten Bereichen der Resistschicht. Dies ist aber bei Positiv-Prozessen völlig unerwünscht.

Hexamethylentetramin und Benzylamin-Verbindungen sind säurelabil. Diese Säurelabilität zeigt sich in verstärktem Masse in Gegenwart von Novolak-Harzen. Säurespuren sind in Positiv-Fotoresists, herstellungsbedingt durch die Novolak-Harze, praktisch unvermeidbar; auch führt die kaum völlig unterbindbare Zersetzung der im Resist enthaltenen Chinondiazid-Komponente zu sauren Abbauprodukten. Zusätze dieser Art führen daher durch säureinduzierten Abbau ebenfalls zu unkalkulierbaren unerwünschten Vernetzungen in der Fotoresistlösung wie auch in der Fotoresistschicht.

Die bislang bekannten Methoden zur Verbesserung der thermischen Stabilität von Fotoresists stellen also aufgrund der ihnen innewohnenden negativen Einflüsse noch keine Ideallösung für dieses Problem dar.

Der Erfindung lag daher die Aufgabe zugrunde, Additive aufzufinden, die in Positiv-Fotoresists auf Basis von alkalilöslichem Phenolharz und fotoempfindlichen Chinondiazidverbindungen in wirksamer Weise die Stabilität damit hergestellter Reliefstrukturen gegenüber Veränderungen durch thermische Einwirkungen erhöhen, ohne dabei die übrigen Eigenschaften negativ zu beeinflussen.

Ueberraschend wurde nun gefunden, dass Verbindungen der Formel I

$$R^1\text{-}SO_2\text{-}CHR^2\text{-}X \qquad (I),$$

worin X OH oder $NR^3R^4$ bedeutet, $R^1$ bis $R^4$ unabhängig voneinander je ein Alkyl, Cycloalkyl, Aryl, Aralkyl mit bis zu 12 C-Atomen bedeuten, wobei diese unsubstituiert oder ein- oder mehrfach substituiert sind mit OH, Halogen, Cyano, Nitro, Alkyl, Alkoxy, Alkylthio, Mono- oder Bisalkylamino, Alkanoyl, Alkanoyloxy, Alkanoylamido, Alkoxycarbonyl, Alkylaminocarbonyl, Aryloxy mit jeweils bis zu 6 C-Atomen, $R^2$ und $R^3$ zusätzlich noch Wasserstoff und $R^4$ zusätzlich noch die Gruppe $R^1\text{-}SO_2\text{-}CHR^2$- bedeuten, für diesen Zweck vorzüglich geeignet sind.

Gegenstand der Erfindung sind dementsprechend Positiv-Fotoresists, enthaltend in einem organischen Lösungsmittel im wesentlichen mindestens je

    a) ein alkalilösliches Phenolharz,

    b) eine fotoempfindliche Chinondiazid-Verbindung sowie gegebenenfalls weitere übliche Zusatzstoffe, die mindestens eine Verbindung der Formel I in einem die Stabilität damit hergestellter Fotoresist-Reliefstrukturen gegenüber Veränderungen durch thermische Einwirkungen steigernden Anteil enthalten.

Gegenstand der Erfindung ist weiterhin die Verwendung von Verbindungen der Formel I als Additive in Positiv-Fotoresists auf Basis von alkalilöslichem Phenolharz und lichtempfindlichen Chinondiazid-Verbindungen zur Steigerung der Stabilität damit hergestellter Fotoresist-Reliefstrukturen gegenüber Veränderungen durch thermische Einwirkungen.

Die erfindungsgemäss den Positiv-Fotoresists zur Steigerung der thermischen Stabilität zuzusetzenden Additive der Formel I sind Verbindungen vom Typ der $\alpha$-Hydroxy- bzw. $\alpha$-Aminosulfone, die sich durch die nachfolgenden Formeln Ia-Ic näher spezifizieren lassen.

$$R^1\text{-}SO_2\text{-}CHR^2\text{-}OH \qquad (Ia),$$
$$R^1\text{-}SO_2\text{-}CHR^2\text{-}NR^3R^4 \qquad (Ib) \text{ und}$$
$$R^1\text{-}SO_2\text{-}CHR^2\text{-}NR^3\text{-}CHR^2\text{-}SO_2\text{-}R^1 \qquad (Ic).$$

Es handelt sich hierbei um im wesentlichen bekannte Verbindungen, die in einfacher Weise nach üblichen Syntheseverfahren hergestellt werden können. Verbindungen der Formel Ia sind durch Addition entsprechender Sulfinsäurevorstufen an Aldehyde zugänglich. Durchführung dieser Addition in Gegenwart entsprechender Amine oder nach folgende Aminierung der Verbindungen der Formel Ia führt zu den Verbindungen der Formeln Ib bzw. Ic.

In den Formeln I bzw. Ia, Ib und Ic kann $R^1$ Alkyl, Cycloalkyl, Aryl, Aralkyl mit bis zu 12 C-Atomen, jeweils gegebenenfalls ein- oder mehrfach substituiert mit OH, Halogen, Cyano, Nitro, Alkyl, Alkoxy, Alkylthio, Mono- oder Bisalkylamino, Alkanoyl, Alkanoyloxy, Alkanoylamido, Alkoxycarbonyl, Alkylaminocarbonyl, Aryloxy, jeweils mit bis zu 6 C-Atomen, bedeuten.

$R^2$, $R^3$ und $R^4$ können unabhängig die gleiche Bedeutung wie $R^1$ haben und zusätzlich noch für Wasserstoff stehen. Bevorzugt steht in diesen Formeln $R^1$ für Phenyl oder substituiertes Phenyl; $R^2$, $R^3$ und $R^4$ bedeuten bevorzugt Wasserstoff. Besonders bevorzugt sind Verbindungen der Formel Ia, insbesondere solche, in denen $R^1$ Phenyl oder substituiertes Phenyl und $R^2$ Wasserstoff ist.

Typische Beispiele derartiger Verbindungen sind Hydroxymethylsulfonylbenzol, 1-(Hydroxymethylsulfonyl)-4-methylbenzol, 1-(Hydroxymethylsulfonyl)-4-methoxybenzol, 1-(Hydroxymethylsulfonyl)-4-chlorbenzol und 1-(Hydroxymethylsulfonyl)-4-nitrobenzol.

Typische Vertreter für Verbindungen der Formel Ib sind etwa Phenyl-(phenylsulfonylmethyl)-amin, Phenyl-(p-tolylsulfonylmethyl)-amin, (3-Nitrophenyl)-(4-methylphenylsulfonyl)-phenylaminomethan und Benzyl-(4-methylphenylsulfonyl)-phenylaminomethan. Typische Beispiele für Verbindungen der Formel Ic sind etwa Bis(phenylsulfonylmethyl)-amin und Bis(p-tolylsulfonylmethyl)-amin.

Die Verbindungen der Formel I bewirken, wenn als Additive in Positiv-Fotoresists auf Basis von alkalilöslichem Phenolharz und lichtempfindlichen Chinondiazidverbindungen eingearbeitet, eine äusserst effektive Stabilisierung von mit derartigen Fotoresists hergestellten Reliefstrukturen gegenüber Veränderungen durch thermische Einwirkungen. Dies zeigt sich besonders deutlich in der Verhinderung der Kantenverrundung bei Temperaturen über 120°C. Es wird angenommen, dass die Verbindungen der Formel I in den entwickelten Fotoresist-Reliefstrukturen bei Einwirkung von erhöhten Temperaturen eine Vernetzung bewirken. Die Einsatzmenge ist weitgehend unkritisch und lässt sich leicht für die jeweilige Einzelverbindung und die jeweilige Resistformulierung in einfachen Routineuntersuchungen ermitteln und optimieren. Als zweckmässiger Mengenbereich hat sich 0,1-10 Gew.%, bezogen auf die Gesamtmenge der Fotoresistlösung, erwiesen. Besonders günstig sind die Ergebnisse, wenn die Verbindungen der Formel I in einem Anteil von 1-5 Gew.%, bezogen auf die Gesamtmenge der Fotoresistlösung, enthalten sind. Bei Einsatz in den angegebenen Mengenbereichen konnten keine negativen Einflüsse auf die übrigen Eigenschaften des Fotoresist festgestellt werden. Insbesondere trat keine vorzeitige Vernetzung in der Resistlösung bzw. in den bestrahlten Bildbereichen der Resistschicht ein.

Die erfindungsgemäss durch die Additive der Formel I gegenüber thermische Einflüsse stabilisierten Positiv-Fotoresists entsprechen hinsichtlich ihrer Hauptbestandteile, nämlich alkalilösliches Phenolharz und lichtempfindliche Chinondiazidverbindung, im wesentlichen den heute hierfür üblichen qualitativen und quantitativen Zusammensetzungen.

Als Harzkomponente sind im Prinzip alle in der Fotoresist-Technik üblichen alkalilöslichen Phenolharze geeignet, wie z.B. Novolak-Harze, die durch Kondensation von Phenol bzw. phenolischen Verbindungen mit Aldehyden erhalten werden. Bevorzugt sind Kresol-Formaldehyd-Harze, zu deren Herstellung o-, m-, p-Kresol oder Mischungen dieser Isomeren in beliebigen oder vorbestimmten Verhältnissen eingesetzt werden. Die Herstellung solcher Harze und ihr Einsatz in Positiv-Fotoresists ist z.B. im US-Patent 4,377,631 beschrieben. Neben diesen Harzen kommen auch zusätzlich andere alkalilösliche Harze in Frage, wie sie vielfach in Positiv-Fotoresists verwendet werden. Dazu gehören etwa Poly-Vinylphenole und Poly-Glutarimide, Copolymere aus Styrol und α-Methylstyrol mit Maleinimid sowie Copolymere aus N-(p-Hydroxyphenyl)-maleinimid und Olefinen. Weiterhin können auch silylierte Derivate alkalilöslicher Polymere verwendet werden, die eine höhere Plasmaätzbeständigkeit aufweisen. In Positiv-Fotoresists bildet die Harzkomponente normalerweise einen Anteil von etwa 40-70 Gew.%, bezogen auf den Gesamtfeststoffgehalt.

In den erfindungsgemässen Positiv-Fotoresists werden bevorzugt m-Kresol-Novolakharze mit relativ hoher mittlerer Molmasse, bevorzugt zwischen etwa 8000 und 18000, und enger Molmassenverteilung eingesetzt.

Als fotoempfindliche Chinondiazidverbindungen sind in Positiv-Fotoresists üblicherweise Veresterungsprodukte der 1,2-Naphthochinon-2-diazid-5-sulfonsäure oder 1,2-Naphthochinon-2-diazid-4-sulfonsäure mit niedermolekularen aromatischen Hydroxyverbindungen, insbesondere Hydroxybenzophenonen wie 2,3,4-Trihydroxybenzophenon und 2,3,4,4'-Tetrahydroxybenzophenon sowie Trihydroxybenzolen wie 1,3,5-Trihydroxybenzol, im Gebrauch. Diese Naphthochinondiazidverbindungen verfügen über eine breite Absorption im nahen bis mittleren UV-Wellenlängenbereich zwischen ca. 300 und 450 nm. In diesem Wellenlängenbereich liegen kräftige Emissionslinien der üblicherweise in den Projektionsgeräten eingesetzten Quecksilberlampen, wie etwa die Linien bei 313 nm, 334 nm, 365 nm, 405 nm und 436 nm.

Als fotoempfindliche Komponenten werden in den erfindungsgemässen Positiv-Fotoresists bevorzugt, 1,2-Naphthochinondiazid-5-sulfonylester von Trihydroxybenzol-Isomeren eingesetzt. Es können dies sein die Trisester von 1,2,3-, 1,2,4- und 1,3,5-Trihydroxybenzol. Diese Verbindungen sind bekannt und können in einfacher Weise durch Veresterung der entsprechenden Trihydroxybenzol-Isomeren mit 1,2-Naphthochinondiazid-5-sulfonylchlorid als reine Vollester erhalten werden. Die isomeren Formen dieser Trisester werden normalerweise rein eingesetzt, können aber auch im Gemisch miteinander verwendet werden. Ihr Einsatz in den erfindungsgemässen Positiv-Fotoresists erfolgt in einem Anteil, so dass für die fotobleichbare Absorption (A-Wert) ein Absorptionskoeffizient von mindestens 0,4 $\mu m^{-1}$ resultiert.

Vorzugsweise liegt der einzustellende A-Wert im Bereich zwischen 0,50 und 0,75 $\mu m^{-1}$ bei einer Bestrahlungswellenlänge von 436 nm. Dies ist in Abhängigkeit der geringfügig variierenden molaren Extinktionen dieser Isomeren ab einem Gehalt von etwa 15 Gew.%, bezogen auf den Gesamtfeststoffgehalt, der Fall. Besonders bevorzugt als strahlungsempfindliche Komponente ist der 1,2-Naphthochinondiazid-5-sulfonyltrisester von 1,3,5-Trihydroxybenzol. Dieser wird vorzugsweise in einer Konzentration von 17-30 Gew.%, bezogen auf den Gesamtfeststoffgehalt, eingesetzt.

Zu den weiteren üblichen Zusatzstoffen, die auch in den erfindungsgemässen siliziumhaltigen Fotoresistzusammensetzungen enthalten sein können, gehören die Fotoempfindlichkeit und/oder die Entwicklungsrate steigernde Verbindungen, etwa aromatische Hydroxyverbindungen, wie Polyhydroxybenzophenone oder Benzotriazolderivate, sowie streustrahlungsabsorbierende Substanzen und Farbstoffe, Verlaufmittel, Weichmacher, Haftvermittler, Tenside und Stabilisatoren. Zusätze dieser Kategorien sind dem Fachmann ausreichend bekannt und sind vielfältig in der einschlägigen Fachliteratur beschrieben. Der Anteil an solchen Zusätzen übersteigt zusammengenommen kaum 30 Gew.%, bezogen auf den Gesamtfeststoffgehalt der Fotoresist-Lösung.

Als derartige Additive enthalten die erfindungsgemässen Positiv-Fotoresists zur Steigerung der Entwicklungsrate bevorzugt eine aromatische Hydroxyverbindung in einem Anteil von 5-30 Gew.%, bezogen auf den Gesamtfeststoffgehalt.

Es kommen hierfür etwa die Verbindungen in Frage:
2,3,4-Trihydroxybenzophenon, 4,4'-Dihydroxybiphenyl, 2,2'-Dihydroxybiphenyl, 4,4'-Dihydroxybenzophenon, Bis(4-hydroxyphenyl)ether, Bis(4-hydroxyphenyl)sulfid, Bis(2,4-dihydroxyphenyl)sulfid, Bis(4-hydroxyphenyl)sulfon, 2,2-Bis(4-hydroxyphenyl)prcpan. Besonders bevorzugt sind 2,3,4-Trihydroxybenzophenon, Bis(4-hydroxyphenyl)sulfon, 4,4'-Dihydroxybenzophenon und Bis(2,4-dihydroxyphenyl)sulfid und hiervon insbesondere 2,3,4-Trihydroxybenzophenon.

Die erfindungsgemässen Positiv-Fotoresists enthalten typischerweise
50 bis 65 Gew.% alkalilösliches Harz,
18 bis 25 Gew.% 1,2-Naphthochinondiazid-5-sulfonyltrisester von 1,3,5-Trihydroxybenzol,
15 bis 25 Gew.% 2,3,4-Trihydroxybenzophenon und
1 bis 5 Gew.% an Verbindungen der Formel I,
jeweils bezogen auf den Gesamtfeststoffgehalt.

Als Lösungsmittel zur Herstellung der Fotoresist-Lösung sind im Prinzip alle Lösungsmittel geeignet, in denen die festen Fotoresist-Bestandteile, wie alkalilösliches Harz, Chinondiazidverbindung, Verbindung(en) der Formel I und gegebenenfalls weitere Zusatzstoffe, ausreichend löslich sind und die mit diesen Bestandteilen nicht irreversibel reagieren. In Frage kommen hierfür beispielsweise aliphatische Ketone, wie Methylethylketon, Cyclopentanon oder Cyclohexanon, aliphatische Ester, wie Butylacetat, Ether, wie Anisol oder Tetrahydrofuran, Alkohole, wie n- oder i-Propanol, Mono- oder Bisether sowie gemischte Ether-Esterderivate von Glykolverbindungen, wie von Ethylenglykol, Diethylenglykol oder Propylenglykol, des weiteren Monooxocarbonsäureester, wie etwa Milchsäureethylester oder 2-Ethoxypropionsäureethylester, Lactone, wie γ-Butyrolacton, cyclische Amide, wie 2-Methylpyrrolidon. Aliphatische und aromatische Kohlenwasserstoffe, wie n-Hexan und Xylol finden ebenfalls Verwendung als Lösungsmittel. Vielfach werden auch Gemische aus den genannten Lösungsmitteln verwendet. Verbreitet enthalten Fotoresist-Lösungsmittel Ethoxyethylacetat, Methoxypropylacetat oder Ethylenglykoldi methylether. Das Lösungsmittel hat üblicherweise einen Anteil von 40-90 Gew.% an der gesamten Fotoresist-Lösung.

Die Formulierung der erfindungsgemässen Positiv-Fotoresists erfolgt in an sich bekannter Weise durch Mischen bzw. Lösen der Komponenten in dem Lösungsmittelgemisch, wobei die erfindungsgemäss einzusetzenden Additive zugesetzt werden. Gleichermassen ist es möglich, fertigformulierte Positiv-Fotoresists, wie sie etwa im Handel sind, mit der entsprechenden Menge an Additiv zu versetzen. Nach Lösen der Bestandteile im Lösungsmittel wird die erhaltene Fotoresist-Lösung je nach Anspruch an die Partikelfreiheit durch Membranfilter mit einer Porenweite von 0,1-1 μm filtriert. Ueblicherweise wird der Gesamtfeststoffgehalt des Fotoresist auf die gewünschte Schichtdicke und Beschichtungsmethode abgestimmt.

Die Anwendung der erfindungsgemässen Positiv-Fotoresists erfolgt nach an sich bekannten Verfahren und mit den hierfür üblichen Prozessgeräten. Zunächst wird die Fotoresist-Lösung auf das Substrat aufgebracht und getrocknet. Als Substrate fungieren überwiegend Halbleiterscheiben, wie z.B. Silizium-Wafer, die gegebenenfalls mit einer Schicht aus Siliziumdioxid, Siliziumnitrid oder Aluminium überzogen sind. Auch andere, bei der Herstellung miniaturisierter Schaltungen übliche Materialien wie Germanium, Galliumarsenid, Keramik mit gegebenenfalls Edelmetallbeschichtung kommen in Frage.

Die Beschichtung erfolgt üblicherweise durch Tauchen, Sprühen, Walzen oder Aufschleudern. Bei der letzteren, am häufigsten angewandten Beschichtungsmethode ist die resultierende Schichtdicke abhängig von der Viskosität der Fotoresist-Lösung, dem Feststoffgehalt und der Aufschleudergeschwindigkeit. Für den jeweiligen Fotoresist werden sogenannte Schleuderkurven ermittelt, aus denen sich die Resist-Schichtdicken in Abhängigkeit von Viskosität und Schleuderdrehzahl ermitteln lassen. Die Schichtdicken bei Positiv-Fotoresists liegen typischerweise im Bereich von 0,5-4 μm, insbesondere bis 2 μm.

Nachdem der Fotoresist auf das Substrat aufgebracht worden ist, wird er normalerweise bei Temperaturen zwischen 70°C und 130°C vorgetrocknet. Dazu können Öfen oder Heizplatten verwendet werden. Die Trocknungszeit in Öfen liegt im Bereich von etwa 15-45 Minuten, auf Heizplatten im Bereich von etwa 0,5-4 Minuten. Vorzugsweise werden 0,5-2 μm dicke Resistschichten etwa 1 Minute bei etwa 100°C auf der Heizplatte getrocknet.

Der getrocknete Fotoresist wird dann durch eine Maske hindurch bildmässig belichtet, wobei Strahlung mit einer Wellenlänge im Bereich von etwa 300 nm bis 450 nm verwendet wird. Die Belichtung kann poly- oder monochromatisch erfolgen. Bevorzugt werden hierzu kommerziell erhältliche Geräte, wie z.B. Scanning-Projektions-Belichtungsgeräte, Kontakt- und Abstands-Belichtungsgeräte oder Wafer-Stepper, eingesetzt.

Bevorzugt werden die erfindungsgemässen Positiv-Fotoresists monochromatisch bei 436 nm belichtet, wobei ihre vorzüglichen Auflösungseigenschaften besonders günstig in Erscheinung treten.

Die mit dem Fotoresist beschichteten und belichteten Substrate werden schliesslich mit einer wässrig-alkalischen Entwicklerlösung, z.B. durch Tauchen oder Besprühen, entwickelt, bis in den belichteten Bereichen der Resist vollständig abgelöst ist. Es können verschiedene Entwicklerformulierungen verwendet werden, die entweder zur Klasse der metallionenhaltigen oder metallionenfreien Fotoresistentwickler gehören. Metallionenhaltige Entwickler sind wässrige Lösungen von Natriumhydroxid oder Kaliumhydroxid, die darüber hinaus pH-regulierende und puffernde Substanzen, wie Phosphate oder Silikate sowie Tenside und Stabilisatoren enthalten können. Metallionenfreie Entwickler enthalten statt alkalischer Metallverbindungen organische Basen, wie z.B. Tetramethylammoniumhydroxid oder Cholin. Die Entwicklungszeiten hängen von der Belichtungsenergie, Stärke des Entwicklers, Art des Entwickelns, der Vortrocknungstemperatur und der Entwicklertemperatur ab. Bei der Tauchentwicklung sind Entwicklungszeiten von etwa 1 Minute typisch. Die Entwicklung wird üblicherweise durch Eintauchen oder Besprühen mit deionisiertem Wasser gestoppt. An die Entwicklung schliesst sich normalerweise eine Nachtrocknung bei etwa 120°C bis 180°C an.

Gerade durch den Gehalt an Verbindungen der Formel I erweisen sich die erfindungsgemässen Positiv-Fotoresists als besonders wertvoll für die praktische Anwendung, da in diesem Nachtrocknungsschritt Strukturveränderungen wie durch die erhöhte Temperatur und Dauer der Nachtrocknung verursachte Fliessvorgänge, Kantenverrundungen etc. nicht mehr auftreten.

Die mit den erfindungsgemässen Fotoresists hergestellten Reliefstrukturen zeigen eine vorzügliche Bildauflösung bis herab zu wenigstens 0,6 μm bei hohem Kontrast, hoher Kantensteilheit und Kantenschärfe. Der Schichtdickenverlust in den unbelichteten Bereichen ist minimal. In den nachfolgenden Prozessabläufen bei der Herstellung von integrierten Halbleiterschaltungen, wie Aetzen mit Säure oder im Plasma, Dotieren oder Beschichten, zeigen sie hervorragende Eigenschaften und gewährleisten einen wirksamen Schutz der mit den Fotoresist-Reliefstrukturen abgedeckten Bereiche des Schichtträgers.

Beispiele

A. Fotoresist-Formulierungen

Es wurden 2 Fotoresist-Stammformulierungen hergestellt in Form 35%-iger Lösungen in Diethylenglykoldimethylether, enthaltend
60,0 Gew.% m-Kresol-Novolak-Harz mit mittlerer Molmasse M $\overline{w}$ = 9000 (Harz 1) bzw. M $\overline{w}$ = 16000 (Harz 2)
18,9 Gew.% 1,2-Naphthochinondiazid-5-sulfonyltrisester von 1,3,5-Trihydroxybenzol
22,0 Gew.% 2,3,4-Trihydroxybenzophenon
bezogen auf den Gesamtfeststoffgehalt. Proben dieser Lösungen wurden mit folgenden Additiven der Formel I in den unter C. angegebenen prozentualen Mengen, bezogen auf die gebrauchsfertigen Resistlösungen, versetzt:
Hydroxymethylsulfonylbenzol (Nr. 1)
1-(Hydroxymethylsulfonyl)-4-methylbenzol (Nr. 2)
1-(Hydroxymethylsulfonyl)-4-methoxybenzol (Nr. 3)
1-(Hydroxymethylsulfonyl)-4-chlorbenzol (Nr. 4)
1-(Hydroxymethylsulfonyl)-4-nitrobenzol (Nr. 5)
Diese Lösungen und Vergleichsproben der Stammlösung wurden durch einen Filter mit 0,2 μm Porenweite filtriert.

B. Versuchsmethodik

Die Fotoresist-Formulierungen wurden auf oberflächlich oxidierte Silizium-Scheiben von 4 Zoll (= 100 mm) Durchmesser aufgeschleudert, wobei die Schleuderdrehzahl so gewählt wurde, dass nach dem Trocknen auf die Heizplatte für 1 Minute bei 100°C eine Schichtdicke von jeweils 1,5 μm resultierte.

Danach wurde durch eine Auflösungstestmaske monochromatisch bei 436 nm mit einer Optik der numerischen Apertur NA = 0,35 belichtet und anschliessend durch Eintauchen in 1,62%-ige wässrige Tetramethylammoniumhydroxid-Lösung bei 20°C für 60 Sekunden entwickelt.

Die Prüfung der thermischen Belastbarkeit der erhaltenen Reliefstrukturen erfolgte auf der Heizplatte für 1 Minute sowie im Umluftofen für 30 Minuten, jeweils bei 120° C und 140° C.

Die Inspektion der erhaltenen Resiststrukturen erfolgte unter dem Rasterelektronenmikroskop hinsichtlich Kantenschärfe bzw. eingetretene Kantenverrundung nach folgendem Beurteilungsmassstab: 1 = scharfe Kanten, keine Kantenverrundung 2 = geringe Kantenverrundung 3 = deutliche Kantenverrundung 4 = sehr starke Kantenverrundung

C. Ergebnis

Die nachfolgende Tabelle zeigt, dass die Resiststrukturen mit den erfindungsgemässen Formulierungen (Beispiele 1-6,8,9) aufgrund des Gehaltes an Additiven der Formel I eine erheblich bessere thermische Stabilität besitzen als die Formulierungen ohne Additiv (Vergleichsbeispiele 7 und 10).

| Beispiel | Additiv Nr./Konzentration | Harz | Thermische Stabilität | | | |
|---|---|---|---|---|---|---|
| | | | Heizplatte | | Ofen | |
| | | | 120° C | 140° C | 120° C | 140° C |
| 1 | 1 / 2 % | 1 | 1 | 2 | 1 | 2 |
| 2 | 2 / 2 % | 1 | 1 | 2 | 1 | 2 |
| 3 | 2 / 4 % | 1 | 1 | 1 | 1 | 1 |
| 4 | 3 / 2 % | 1 | 1 | 2 | 1 | 2 |
| 5 | 4 / 2 % | 1 | 1 | 2 | 1 | 2 |
| 6 | 5 / 2 % | 1 | 1 | 2 | 1 | 2 |
| 7 (Vergleich) | - / - % | 1 | 3 | 4 | 3 | 4 |
| 8 | 2 / 2 % | 2 | 1 | 2 | 1 | 2 |
| 9 | 2 / 4 % | 2 | 1 | 1 | 1 | 1 |
| 10 (Vergleich) | - / - % | 2 | 3 | 4 | 3 | 4 |

**Ansprüche**

1. Positiv-Fotoresists, enthaltend in einem organischen Lösungsmittel im wesentlichen mindestens je
a) ein alkalilösliches Phenolharz,
b) eine fotoempfindliche Chinondiazid-Verbindung
sowie gegebenenfalls weitere übliche Zusatzstoffe, dadurch gekennzeichnet, dass darin mindestens eine Verbindung der Formel I
$R^1$-$SO_2$-$CHR^2$-X     (I),
worin X OH oder $NR^3R^4$ bedeutet, $R^1$ bis $R^4$ unabhängig voneinander je ein Alkyl, Cycloalkyl, Aryl, Aralkyl mit bis zu 12 C-Atomen bedeuten, wobei diese unsubstituiert oder ein- oder mehrfach substituiert sind mit OH, Halogen, Cyano, Nitro, Alkyl, Alkoxy, Alkylthio, Mono- oder Bisalkylamino, Alkanoyl, Alkanoyloxy, Alkanoylamido, Alkoxycarbonyl, Alkylaminocarbonyl, Aryloxy mit jeweils bis zu 6 C-Atomen, $R^2$ und $R^3$ zusätzlich noch Wasserstoff und $R^4$ zusätzlich noch die Gruppe $R^1$-$SO_2$-$CHR^2$- bedeuten, in einem die Stabilität damit hergestellter Fotoresist-Reliefstrukturen gegenüber Veränderungen durch thermische Einwirkungen steigernden Anteil enthalten ist.

2. Positiv-Fotoresists nach Anspruch 1, dadurch gekennzeichnet, dass darin 0,1 bis 10 Gew.%, vorzugsweise 1 bis 5 Gew.%, bezogen auf die Gesamtmenge, mindestens einer Verbindung der Formel I enthalten sind.

3. Positiv-Fotoresists nach Anspruch 1 oder 2, dadurch gekennzeichnet, dass darin als Verbindung der Formel I mindestens eine Verbindung aus der Gruppe
Hydroxymethylsulfonylbenzol
1-(Hydroxymethylsulfonyl)-4-methylbenzol
1-(Hydroxymethylsulfonyl)-4-methoxybenzol
1-(Hydroxymethylsulfonyl)-4-chlorbenzol
1-(Hydroxymethylsulfonyl)-4-nitrobenzol

enthalten ist.

4. Verwendung von Verbindungen der Formel I als Additive in Positiv-Fotoresists auf Basis von alkalilöslichem Phenolharz und lichtempfindlichen Chinondiazid-Verbindungen zur Steigerung der Stabilität damit hergestellter Fotoresist-Reliefstrukturen gegenüber Veränderungen durch thermische Einwirkungen.